# EUROPÄISCHE PATENTSCHRIFT

(11) **EP 3 732 727 B1**
(45) Veröffentlichungstag und Bekanntmachung des Hinweises auf die Patenterteilung: **31.08.2022**
(21) Anmeldenummer: 18829351.8
(22) Anmeldetag: 19.12.2018
(51) Int. Cl.: H01L 29/737, H01L 29/739, H01L 29/786

(54) **ZWEIKANAL-HALBLEITERBAUELEMENT**
TWO-CHANNEL SEMICONDUCTOR COMPONENT
COMPOSANT SEMI-CONDUCTEUR À DEUX CANAUX

(30) Priorität: 29.12.2017 DE 102017131452; 26.02.2018 DE 102018104305
(43) Veröffentlichungstag der Anmeldung: 04.11.2020
(73) Patentinhaber: Brandenburgische Technische Universität Cottbus-Senftenberg, 03046 Cottbus (DE)
(72) Erfinder: REICHENBACH, Martin, 06925 Annaburg (DE); WULF, Ulrich, 03046 Cottbus (DE); RICHTER, Hans, 15236 Frankfurt (Oder) (DE)
(74) Vertreter: Eisenführ Speiser
(86) Internationale Anmeldenummer: PCT/EP2018/085822
(87) Internationale Veröffentlichungsnummer: WO 2019/129571

(56) Entgegenhaltungen:
- EP-A1- 2 568 506
- US-A1- 2015 221 499
- TSUTSUI M ET AL: "Proposal and analysis of coupled channel tunneling FET with new heterostructures on silicon", SOLID STATE ELECTRONICS, ELSEVIER SCIENCE PUBLISHERS, BARKING, GB, Bd. 42, Nr. 7-8, 8. Juli 1998 (1998-07-08) , Seiten 1547-1551, XP004133507, ISSN: 0038-1101, DOI: 10.1016/S0038-1101(98)00068-9
- KIM SANG WAN ET AL: "Hump Effects of Germanium/Silicon Heterojunction Tunnel Field-Effect Transistors", IEEE TRANSACTIONS ON ELECTRON DEVICES, IEEE SERVICE CENTER, PISACATAWAY, NJ, US, Bd. 63, Nr. 6, 1. Juni 2016 (2016-06-01), Seiten 2583-2588, XP011610719, ISSN: 0018-9383, DOI: 10.1109/TED.2016.2555928 [gefunden am 2016-05-19]

## Beschreibung

Die vorliegende Erfindung betrifft Halbleiterbauelemente mit zwei räumlich getrennten Leitfähigkeitskanälen. Solche Bauelemente werden auch als Zweikanal-Bauelemente bezeichnet.

Die Erzeugung und Gate-Steuerung von Leitfähigkeitskanälen in Halbleiterbauelementen mit Hilfe des Feldeffektes ist von Feldeffekt-Transistoren her gründlich bekannt und in diesen Bauelementen in verschiedenster Ausprägung technologisch hoch entwickelt. Eine besondere Gruppe bilden Bauelemente mit zwei räumlich getrennten Kanälen. Sie eignen sich für den Einsatz als besonders schnelle Schalter und als Signalmischer. Am Rande wird angemerkt, dass anstelle des Begriffs Leitfähigkeitskanal in der vorliegenden Anmeldung mit gleicher Bedeutung auch von einem Leitungskanal oder schlicht von einem Kanal gesprochen wird.

Bei bekannten Zweikanal-Bauelemente mit Gate-Steuerung kann eine Kopplung zwischen den Leitfähigkeitskanälen durch einen resonanten Tunneleffekt erzielt werden. Derartige bekannte Zweikanal-Bauelemente unterscheiden sich hinsichtlich ihrer Dimensionalität der Leitungskanäle, also in der räumlichen Einschränkung der Ladungsträgerbeweglichkeit in den Leitungskanälen auf eine Ebene oder eine Linie, hinsichtlich der Kontaktierung der Leitungskanäle und hinsichtlich des jeweils verwendeten Materialsystems.

Als Materialsysteme werden im Stand der Technik einerseits III-V Halbleiter Heterostrukturen, z. B. GaAs/AlGaAs, und andererseits CMOS-kompatible und daher technologisch und wirtschaftlich besonders interessante Halbleiter/Oxid-Strukturen wie zum Beispiel Si/SiO2-Strukturen verwendet.

Da GaAs/AlGaAs Heterostrukturen epitaktisch hergestellt werden können, weisen die Wellenfunktionen der Ladungsträger dort große Kohärenzlängen auf, und es können ein- und zweidimensionale Ladungsträgergase als Kanäle verwendet werden.

In bekannten III-V Halbleiterheterostrukturen wurde weiterhin eine Möglichkeit einer selektiven (getrennten, also nicht parallelen) Kontaktierung der Source-/Drain-Elektroden durch so genannte Depletion-Gates (depletion, engl. Ausdruck für Ladungsträger-Verarmung) realisiert, die zusätzlich zum jeweiligen Steuer-Gate vorgesehen sind. Für jeden Kanal ist ein jeweiliges Depletion-Gate vorgesehen. Durch Anlegen einer geeigneten Spannung an ein betreffendes Depletion-Gate wird der zugeordnete Kanal lokal unterhalb bzw. oberhalb des Depletion-Gates an freien Ladungsträgern verarmt und somit unterbrochen und vom danebenliegenden Source- oder Drain-Kontakt abgetrennt. Solange die Trennung besteht, ist der abgetrennte Kontakt nur mit dem jeweils anderen Kanal verbunden.

Die in III-V-Halbleitern eingesetzte Methode des Depletion-Gates setzt eine Barriere zwischen den Leitungskanälen voraus, beispielsweise in Form einer AlGaAs-Trennschicht zwischen GaAs-Kanälen. Ohne eine solche Barriere würde eine Verarmungsspannung an einem Depletion-Gate nur ein unerwünschtes Zusammenführen der beiden Leitungskanäle bewirken.

Die mit einem Depletion-Gate im III-V-Materialsystem erreichten lateralen Bauelementausmaße liegen im Mikrometerbereich, was gemessen am heutigen Stand der siliziumbasierten CMOS-Technologie unverhältnismäßig groß ist.

Mit dem Materialsystem der Gruppe-IV-Halbleiter, welches das Rückgrat der in der Halbleiterindustrie eingesetzten CMOS-Technologie bildet, wurden bei den in der Massenproduktion üblichen Feldeffekt- oder Bipolartransistoren erhebliche Fortschritte in der Miniaturisierung der Bauelemente erreicht, mit Kanallängen bis hinab zu etwa 10nm. Eine Barriere zwischen den Leitungskanälen, wie sie in Multikanalbauelementen unter Verwendung von III-V-Halbleitern eingesetzt wird, ist jedoch in der siliziumbasierten CMOS-Technologie nicht in entsprechender Weise verfügbar. Es wäre zudem wünschenswert, in einem Zweikanal-Halbleiterbauelement auch eine Vierpolgeometrie umsetzen zu können.

US 2017/0098716 A1 zeigt einen Feldeffekttransistor aus zweidimensionalen, durch eine Zwischenschicht voneinander getrennten Monolagen, der das Tunneln von Ladungsträgern ermöglicht.

US 2014/0014905 A1 beschreibt einen Feldeffekttransistor, der eine Graphen-Kanalschicht auf einem Substrat enthält.

Aus EP 2 568 506 A1 ist ein Tunneltransistor bekannt, der neben Source und Drain zwei Gates zur Steuerung eines Stromflusses zwischen Source und Drain aufweist.

Die vorliegende Erfindung schlägt nun ein verbessertes Zweikanal-Halbleiterbauelement vor, umfassend
- einen dotierten Halbleiterkörper eines ersten Leitfähigkeitstyps aus einem Gruppe-IV-Halbleitermaterial;
- eine oberseitige Top-Gate-Elektrode;
- eine unterseitige Bottom-Gate-Elektrode,
- eine erste Source-Elektrode mit einem im Halbleiterkörper ausgebildeten dotierten ersten Source-Gebiet eines zweiten, dem ersten Leitfähigkeitstyp entgegengesetzten Leitfähigkeitstyps,
- eine erste Drain-Elektrode mit einem im Halbleiterkörper ausgebildeten dotierten ersten Drain-Gebiet des zweiten Leitfähigkeitstyps, wobei
- das erste Source-Gebiet eine größere Tiefenerstreckung im Siliziumkörper hat als das erste Draingebiet und den Halbleiterkörper gliedert in einen ersten Tiefenabschnitt, der bis zu einer Unterkante des ersten Drain-Gebiets reicht, und in einen zweiten Tiefenabschnitt, der sich in Tiefenrichtung an den ersten Tiefenabschnitt anschließend bis zur Unterseite des Halbleiterkörpers erstreckt;
- lateral gesehen zwischen dem ersten Source-Gebiet und der Top-Gate-Elektrode ein erstes Source-Isolationsgebiet angeordnet ist, welches die Source-Elektrode und die Top-Gate-Elektrode voneinander elektrisch isoliert und welches sich in Tiefenrichtung in den ersten Tiefenabschnitt des Halbleiterkörpers, nicht jedoch in den zweiten Tiefenabschnitt hinein erstreckt;
- lateral gesehen zwischen dem ersten Drain-Gebiet und der Top-Gate-Elektrode ein erstes Drain-Isolationsgebiet angeordnet ist, welches die Drain-Elektrode und die Top-Gate-Elektrode voneinander elektrisch isoliert und welches sich in Tiefenrichtung bis zur Unterkante der Gate-Isolationsschicht erstreckt; wobei
- jeweilige Ausmaße des ersten Source-Gebiets, des ersten Draingebiets, des ersten Source-Isolationsgebiet und des ersten Drain-Isolationsgebiets in Tiefenrichtung so gewählt sind, dass
   - in einem ersten Betriebszustand, in welchem die Top-Gate-Elektrode und die Bottom-Gate-Elektrode mit jeweiligen ersten und zweiten Betriebsspannungen beaufschlagt sind, im ersten Tiefenabschnitt ein erster, lateral vom ersten Source-Gebiet durch das erste Source-Isolationsgebiet getrennter Leitfähigkeitskanal des zweiten Leitfähigkeitstyps ausbildbar ist und im zweiten Tiefenabschnitt ein zweiter Leitfähigkeitskanal des zweiten Leitfähigkeitstyps ausbildbar ist, der vom ersten Leitfähigkeitskanal durch ein sich in Tiefenrichtung zwischen den Leitfähigkeitskanälen erstreckendes Barrieregebiet des Halbleiterkörpers entkoppelt ist, und
   - in einem zweiten Betriebszustand, in welchem die Top-Gate-Elektrode und die Bottom-Gate-Elektrode mit dritten und vierten Betriebsspannungen beaufschlagt sind, die eine Resonanzbedingung erfüllen, der erste und zweite Leitfähigkeitskanal mittels eines Tunneleffekts für Minoritätsladungsträger über das Barrieregebiet des Halbleiterkörpers hinweg miteinander koppelbar sind.

Die erfindungsgemäße Konstruktion eines Zweikanal-Halbleiterbauelements sieht eine besondere Form selektiver Kontaktierung der Kanäle vor, die von herkömmlichen CMOSkompatiblen Feldeffekttransistoren her nicht bekannt ist, jedoch mit der CMOS-Technologie auch bei der heute in der industriellen Fertigung üblichen hohen Skalierung kompatibel ist. Dies sind wesentliche Verbesserungen im Vergleich zu den oben erwähnten, bisher realisierten selektiv kontaktierten Doppelkanalsystemen im GaAs/AlGaAs-Materialsystem mit Kanallängen oberhalb 1µm.

Bei dem erfindungsgemäßen Zweikanal-Halbleiterbauelement hat das erste Source-Gebiet eine größere Tiefenerstreckung im Halbleiterkörper als das erste Draingebiet. So lässt sich der Halbleiterkörper als in zwei Tiefenabschnitte gliedern, nämlich
- in einen ersten Tiefenabschnitt, der bis zu einer Unterkante des ersten Drain-Gebiets reicht, und
- in einen zweiten Tiefenabschnitt, der sich in Tiefenrichtung an den ersten Tiefenabschnitt anschließend bis zur Unterseite des Halbleiterkörpers erstreckt;

Lateral gesehen zwischen dem ersten Source-Gebiet und der Top-Gate-Elektrode ist ein erstes Source-Isolationsgebiet angeordnet, welches die Source-Elektrode und die Top-Gate-Elektrode voneinander elektrisch isoliert. Es erstreckt sich in Tiefenrichtung in den ersten Tiefenabschnitt des Halbleiterkörpers, nicht jedoch in dessen zweiten Tiefenabschnitt hinein. Zugleich ist lateral gesehen zwischen dem ersten Drain-Gebiet und der Top-Gate-Elektrode ein erstes Drain-Isolationsgebiet angeordnet ist, welches die Drain-Elektrode und die Top-Gate-Elektrode voneinander elektrisch isoliert und welches sich in Tiefenrichtung bis zur Unterkante der Gate-Isolationsschicht erstreckt. Auf diese Weise wird im ersten Tiefenabschnitt des Halbleiterkörpers die Ausbildung eines Kanals ermöglicht, der einen direkten Kontakt ausschließlich mit der Drain-Elektrode hat, also lateral vom ersten Source-Gebiet durch das erste Source-Isolationsgebiet getrennt ist.

Durch geeignete Wahl der jeweiligen Ausmaße des ersten Source-Gebiets, des ersten Draingebiets, des ersten Source-Isolationsgebiet und des ersten Drain-Isolationsgebiets in Tiefenrichtung wird zugleich im zweiten Tiefenabschnitt die Ausbildung eines zweiten Leitfähigkeitskanals des zweiten Leitfähigkeitstyps ermöglicht, der vom ersten Leitfähigkeitskanal durch ein sich in Tiefenrichtung zwischen den Leitfähigkeitskanälen erstreckendes Barrieregebiet des Halbleiterkörpers entkoppelt ist. Hierfür wesentlich ist das schon erwähnte Merkmal des erfindungsgemäßen Zweikanal-Halbleiterbauelements, dass das erste Source-Gebiet eine größere Tiefenerstreckung im Halbleiterkörper hat als das erste Draingebiet. Der zweite Leitfähigkeitskanal, welcher durch die unterseitige Bottom-Gate-Elektrode steuerbar ist bildet sich so in direktem Kontakt allein zur Source-Elektrode.

Durch diese Konstruktion wird also sichergestellt, dass Ladungsträger-Transport von der Source-Elektrode zur Drain-Elektrode nur durch resonantes Tunneln von Ladungsträgern durch das ausgebildete Barrieregebiet nach den Gesetzen des quantenmechanischen Tunneleffekts stattfinden kann. Diese quantenmechanische Tunnelkopplung im erfindungsgemäßen Zweikanal-Halbleiterbauelement zwischen den Leitfähigkeitskanälen zeigt ein Resonanzverhalten. auch bei geringer Kanallänge, sogar im Bereich von etwa 10 nm Kanallänge . Infolgedessen können bei scharfer Resonanzausprägung die Kanäle mit sehr kleinen Veränderungen der Top-Gate-Spannung und Bottom-Gate-Spannung vollständig gekoppelt oder entkoppelt werden. Es fließen bei vorliegender Kopplung in den kurzen Kanälen sehr wenige Ladungen über kurze Strecken, was eine hohe Schaltgeschwindigkeit bei geringer Verlustleistung begünstigt.

Das erfindungsgemäße Zweikanal-Halbleiterbauelement realisiert also einen lateralen Stromtransport zwischen Source- und Drain-Elektroden mit Hilfe eines transversalen resonanten Tunnelns von Ladungsträgern zwischen den Leitfähigkeitskanälen.

Es sei erwähnt, dass die Funktion der Source- und Drain-Gebiete im erfindungsgemäßen Zweikanal-Bauelement grundsätzlich austauschbar ist und daher auch die oben gewählten funktionellen Zuordnungen von Elektroden, Halbleitergebieten und Isolationsgebieten zu Source oder Drain austauschbar sind. Der Klarheit der Darstellung halber wird sie hier jedoch auch in der weiteren Beschreibung in der oben gewählten Form beibehalten, ohne damit jedoch eine Einschränkung der vorliegenden Erfindung zu implizieren.

Nachfolgend werden Ausführungsbeispiele des erfindungsgemäßen Zweikanal-Halbleiterbauelements beschrieben.

Das Zweikanal-Halbleiterbauelement ist in einer Ausführungsform als Zweipol-Bauelement ausgebildet.

Die Leitungskanäle haben in bevorzugten Ausführungsformen eine Kanallänge von weniger als 30 nm. Die Kanallänge bezeichnet, wie von herkömmlichen Feldeffekt-Transistoren her bekannt, den lateralen Abstand im Halbleiterkörper, den Ladungsträger bei von der jeweiligen Gate-Elektrode gesteuerter Leitfähigkeit zwischen dem Source- und dem Drain-Gebiet überbrücken. Besondere Ausführungsformen, die mit besonders hoch skalierter CMOS-Technologie erreichbar sind, haben eine Kanallänge von weniger als 20 nm, wie beispielsweise 10 nm, oder sogar nur zwischen 5 und 10 nm. Mit an sich bekannten modernen Technologien kann eine Kanallänge von nur 5 nm erreicht werden.

Ein Beispiel einer geeigneten Dotierstoffkonzentration in den Leitfähigkeitskanälen ist 10¹⁵cm⁻³. Es sind jedoch auch höhere oder niedrigere Werte verwendbar, die vorzugsweise im Bereich zwischen 10¹⁴cm⁻³ und 10¹⁶cm⁻³ liegen.

Die Ausdehnung des Barrieregebiets in Tiefenrichtung, also der Abstand der Leitfähigkeitskanäle voneinander, der im zweiten Betriebszustand durch resonantes Tunneln zu überbrücken ist, beträgt in bevorzugten Ausführungsbeispielen zwischen 10 und 30 nm, vorzugsweise etwa 20 nm. Dieser Abstand kann im Designprozess des Zweikanal-Bauelements durch Vorgabe der Dotierstoffkonzentration im Barrieregebiet gezielt eingestellt werden. Je höher die Dotierstoffkonzentration im Barrieregebiet, desto geringer kann der Abstand des Barrieregebiets gewählt werden. Mit erhöhter Dotierstoffkonzentration wird die energetische Höhe der zu tunnelnden Barriere verändert.

Grundsätzlich sind im Betrieb des Zweikanal-Bauelements beide Gate-Elektroden gleichpolig zu betreiben. Die Erfüllung der Resonanzbedingung für den zweiten Betriebszustand zeigt sich im Zwei-Kanalbauelement bei gegebener Vorspannung der Bottom-Gate-Elektrode beim "Durchspielen" der Spannung an der Top-Gate-Elektrode durch einen Peak des Drainstroms. Die Vorspannung an der Bottom-Gate-Elektrode kann genutzt werden, um die energetische Höhe der Tunnelbarriere über einen gewissen Bereich hinweg einzustellen. Eine energetisch höhere Tunnelbarriere sorgt für eine schärfere Resonanz, was sich also in einem Peak des Drainstroms in einem kleineren Intervall der Spannung an der Top-Gate-Elektrode zeigt. Der Peak des Drainstroms hat bei energetisch höherer Tunnelbarriere eine geringere Maximalamplitude als bei einer im Vergleich niedrigeren Tunnelbarriere. In einer Weiterbildung als Vierpol-Bauelement hat das Zweikanal-Halbleiterbauelement zusätzlich
- ein zweites Source-Gebiet, welches lateral zwischen dem ersten Source-Gebiet und der Top-Gate-Elektrode angeordnet ist, eine geringere Tiefenerstreckung hat als das erste Source-Gebiet und von diesem lateral durch das erste Source-Isolationsgebiet elektrisch isoliert ist, und welches von der der Top-Gate-Elektrode lateral durch ein zweites Source-Isolationsgebiet elektrisch isoliert ist, und
- ein zweites Drain-Gebiet, welches lateral entfernter als das erste Drain-Gebiet von der Top-Gate-Elektrode angeordnet ist, eine größere Tiefenerstreckung hat als das erste Drain-Gebiet und von diesem lateral durch ein zweites Drain-Isolationsgebiet elektrisch isoliert ist und das sich in den zweiten Tiefenabschnitt hineinerstreckt,

In dieser Ausführung sind vorzugsweise jeweilige Ausmaße des ersten und zweiten Source-Gebiets, des ersten und zweiten Draingebiets, des ersten und zweiten Source-Isolationsgebiet und des ersten und zweiten Drain-Isolationsgebiets in Tiefenrichtung so gewählt sind, dass sich der erste Leitfähigkeitskanal in lateraler Richtung zwischen dem zweiten Source-Gebiet und dem ersten Drain-Gebiet erstreckt und der zweite Leitfähigkeitskanal sich in der lateralen Richtung zwischen dem ersten Source-Gebiet und dem zweiten Draingebiet erstreckt.

Das Zweikanal-Halbleiterbauelement ist in einem Anwendungsbeispiel Teil in einem Signalmischer eingesetzt, der also ein Zwei-Kanal-Halbleiterbauelement gemäß der Erfindung oder einer ihrer Ausführungsformen aufweist, dem über die Bottom-Gate-Elektrode ein erstes Eingangssignal zugeführt ist, dem über die Source-Elektrode ein zweites Eingangssignal zugeführt ist, und an dessen Drain-Elektrode über einen Ausgangswiderstand ein Ausgangssignal abgreifbar ist.

In einer anderen Anwendung wird das Zweikanal-Halbleiterbauelement als durchstimmbarer Detektor für elektromagnetische Wellen eingesetzt. Hier kann durch mit einem Abstimmen der Bottom- und Top-Gate-Spannung eine durchstimmbare Empfindlichkeit des Drainstroms für elektromagnetische Wellen entsprechend bestimmter Energie erzielt werden. Die Resonanzbedingung wird bei dieser Anwendung durch die Summe einer voreingestellten statischen energetischen Komponente in Form der beiden Gate-Spannungen sowie einer dynamischen energetischen Komponente in Form der in den Halbleiterkörper eingestrahlten Energie der elektromagnetischen Wellen mit der zu detektierenden Wellenlänge erfüllt. Je intensiver das Licht dieser Wellenlänge einstrahlt, desto höher ist der detektierte Drainstrom.

Nachfolgend werden weitere Ausführungsbeispiele mit Bezug auf die beiliegenden Zeichnungen beschrieben. Es zeigen:
- Fig. 1: eine schematische Darstellung eines Zweikanal-Halbleiterbauelements mit zwei gegateten tunnelgekoppelten Leitungskanälen;
- Fig. 2 und 3: Illustrationen zur Veranschaulichung von Ladungsträgerwellenfunktionen im Bereich der Leitungskanäle des Zweikanal-Halbleiterbauelements der Fig. 1 im Fall resonanter Kopplung der Leitungskanäle (Fig. 2) und im Fall und entkoppelter Leitungskanäle (Fig. 3);
- Fig. 4: eine schematische Darstellung des Zweikanal-Halbleiterbauelements der Fig. 1 mit paralleler Kontaktierung der Source-und Drain-Elektroden zur parallelen Ansteuerung beider Leitungskanäle;
- Fig. 5: eine schematische Darstellung eines Zweikanal-Halbleiterbauelements mit selektiver Kontaktierung jeweils einer Source-oder Drain-Elektroden zur getrennten Ansteuerung der Leitungskanäle;
- Fig. 6: eine schematische Darstellung eines als Vierpol-Bauelement ausgebildeten Zweikanal-Halbleiterbauelements mit selektiver Kontaktierung jeweils beider Source- und Drain-Elektroden zur getrennten Ansteuerung der Leitungskanäle;
- Fig. 7: eine schematische Querschnittsansicht eines Zweikanal-Halbleiterbauelements mit selektiver Kontaktierung jeweils einer Source-oder Drain-Elektroden zur getrennten Ansteuerung der Leitungskanäle;
- Fig. 8: eine schematische Querschnittsansicht eines als Vierpol-Bauelement ausgebildeten Zweikanal-Halbleiterbauelements mit selektiver Kontaktierung jeweils beider Source- und Drain-Elektroden zur getrennten Ansteuerung der Leitungskanäle;
- Fig. 9: eine schematische Querschnittsansicht des Zweikanal-Halbleiterbauelements aus Fig. 7 mit Verschaltung zur Bildung eines Signalmischers;
- Fig. 10: ein Signalbeispiel einer lokalen Oszillator-Spannung Δ*U*(*t*) als Funktion der Zeit, die dem Signalmischer der Fig. 9 zugeführt werden kann;
- Fig. 11: ein Signalbeispiel eines Hochfrequenzsignals *U_{D}*(*t*) als Funktion der Zeit, die dem Signalmischer der Fig. 9 zugeführt werden kann;
- Fig. 12: ein Ausgangssignal des Signalmischers der Fig. 9.

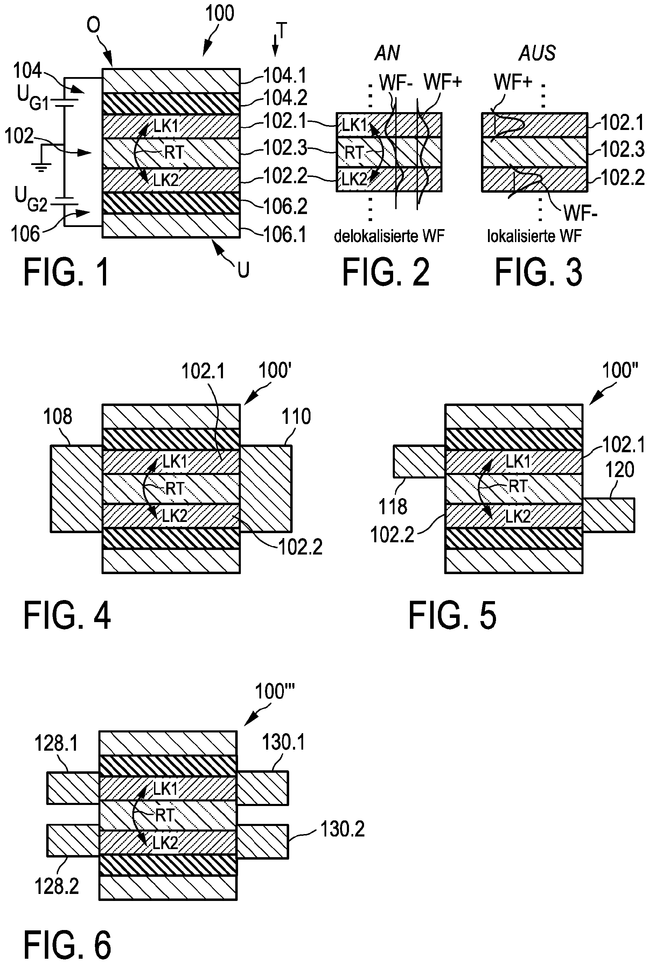

Fig. 1 zeigt eine schematische Darstellung eines Zweikanal-Halbleiterbauelements mit zwei gegateten tunnelgekoppelten Leitungskanälen. Ein Halbleiterkörper in Form eines Siliziumkörpers 102 bildet ein Substrat, auf dessen seiner Oberseite eine Top-Gate-Elektrode 104 und auf dessen Unterseite eine Bottom-Gate-Elektrode 106 hergestellt sind. Anstelle von Silizium kann als Halbleiterkörper auch Germanium oder Silizium-Germanium verwendet werden.

Nachfolgend werden nähere Einzelheiten des vom Siliziumkörper 102 gebildeten Substrats, der Top-Gate-Elektrode 104 und der Bottom-Gate-Elektrode 106 erläutert.

Im Siliziumkörper 102, der als solcher aus p-dotiertem Silizium besteht, sind in dem in Fig. 1 dargestellten Zustand zwei n-Leitfähigkeitskanäle 102.1 und 102.2 ausgebildet, die sich zwischen hier nicht dargestellten Source- und Drain-Elektroden erstrecken und nachfolgendend auch kurz als Leitungskanal 1, 2 oder LK1, LK2 bezeichnet werden. Nähere Details zu unterschiedlichen Möglichkeiten der Ausbildung der Source- und Drain-Elektroden sowie zu den Umständen, unter denen die Leitungskanäle 1 und 2 ausgebildet werden, sind weiter unten erläutert.

Eine Tiefenrichtung T weist von der Oberseite O des Siliziumkörpers 102 zur Unterseite U, also in Stapelrichtung der dargestellten Schichtung. In dieser Tiefenrichtung gesehen bildet der Siliziumkörper 102 zwischen den Leitungskanälen 102.1 und 102.2 eine Barriere 102.2.

Die Top-Gate-Elektrode 104 ist aus einer elektrisch leitfähigen Schicht 104.1 auf einer oberen Gate-Isolationsschicht 104.2 aus dielektrischem Material aufgebaut. Die Gate-Isolationsschicht 104.2 liegt auf der Oberseite des Siliziumkörpers 102 auf.

Die Bottom-Gate-Elektrode 106 ist aus einer elektrisch leitfähigen Schicht 106.1 auf einer unteren Gate-Isolationsschicht 106.2 aus dielektrischem Material aufgebaut. Die untere Gate-Isolationsschicht 106.2 liegt auf der Unterseite des Siliziumkörpers 102 auf.

Fig. 2 und 3 zeigen Illustrationen zur Veranschaulichung von Ladungsträgerwellenfunktionen im Bereich der Leitungskanäle des Zweikanal-Halbleiterbauelements der Fig. 1 im Fall resonanter Kopplung der Leitungskanäle (Fig. 2) und im Fall und entkoppelter Leitungskanäle (Fig. 3). In Fig. 2 sind zusätzlich zu den Leitfähigkeitskanälen 102.1 und 102.2 sowie dem Barrierebereich 102.3 im Siliziumkörper in schematischer Form quantenmechanische Wellenfunktionen WF+ und WF- von Ladungsträgern dargestellt. Die ortsabhängige Darstellung zeigt die Amplituden der Wellenfunktionen am jeweils betreffenden Ort innerhalb des dargestellten Bereiches des Siliziumkörpers 102 an.

Bekanntlich lässt sich aus der Amplitude der quantenmechanischen Wellenfunktion eine Aufenthaltswahrscheinlichkeit am betreffenden Ort ableiten. Beide Wellenfunktionen WF+ und WF- zeigen im Fall der Fig. 2 jeweils zwei Extremwerte, nämlich innerhalb beider Leitungskanäle 102.1 und 102.2, und reduzierte Amplituden im Bereich der Barriere 102.3. Dies entspricht einem wünschenswerten Kopplungszustand zwischen den Leitungskanälen 102.1 und 102.2, der seinen Ausdruck in den dargestellten delokalisierten Wellenfunktionen WF+ und WF+ findet. Die Aufenthaltswahrscheinlichkeit der einzelnen Ladungsträger ist in diesem Fall auf beide Kanäle zugleich verteilt. Dies entspricht der einer Situation, in der durch geeignete Wahl der an die Top- und Bottom-Gate angelegten Steuerspannungen UG1 und UG2 ein resonanter Tunneleffekt hervorgerufen wird. Die Leitungskanäle 102.1 und 102.2 sind also im dargestellten Resonanzfall gekoppelt, indem Ladungsträger zwischen ihnen durch die Barriere 102.3 tunneln können und somit ein Ladungsträger-Tunnelstrom zwischen den Leitungskanälen fließen kann.

Auch in Fig. 3 sind zusätzlich zu den Leitfähigkeitskanälen 102.1 und 102.2 sowie dem Barrierebereich 102.3 im Siliziumkörper in schematischer Form quantenmechanische Wellenfunktionen WF+ und WF- von Elektronen dargestellt, jedoch für den Fall, dass die Leitungskanäle 102.1 und 102.2 von einander entkoppelt sind, was wiederum durch geeignete Auswahl der Steuerspannungen UG1 und UG2 zu bewirken ist.

Die ortsabhängige Darstellung der Wellenfunktionen zeigt, dass die Amplituden der Wellenfunktionen von Elektron innerhalb der Leitungskanäle 102.1 und 102.2 lokalisiert sind und sich nicht in den jeweils anderen Leitungskanal hinein erstrecken. Dies entspricht einem Entkopplungszustand zwischen den Leitungskanälen 102.1 und 102.2, der seinen Ausdruck in den dargestellten stark lokalisierten Wellenfunktionen WF+ und WF- findet. Auch die Aufenthaltswahrscheinlichkeit der einzelnen Ladungsträger ist in diesem Fall stark auf einen der beiden Leitungskanäle beschränkt. Dies entspricht einer Situation, in der durch geeignete Wahl der an die Top- und Bottom-Gate angelegten Steuerspannungen UG1 und UG2 ein resonanter Tunneleffekt vermieden wird.

Ein Umschalten zwischen den beiden Zuständen der Fig. 2 und 3, gekoppelt und entkoppelt, ist also durch geeignete Wahl der Steuerspannungen UG1 und UG2 an Top- und Bottom-Gate-Elektrode zu erzielen.

Nachfolgend werden anhand der Fig. 4 bis 6 Kontaktierungsvarianten für das in Fig. 1 dargestellte Zweikanal-Bauelement dargestellt.

Fig. 4 zeigt eine schematische Darstellung einer ersten Variante 100' des Zweikanal-Halbleiterbauelements der Fig. 1 mit paralleler Kontaktierung der Source-und Drain-Elektroden zur parallelen Ansteuerung beider Leitungskanäle. Bei dieser Form der Kontaktierung stehen eine Source-Elektrode 108 und eine Drain-Elektrode 110 jeweils in unmittelbarem Kontakt mit beiden Leitungskanälen 102.1 und 102.2. Ein Ladungsträgerstrom kann bei dieser Variante auch dann fließen, wenn die angelegten Steuerspannungen UG1 und UG2 keinen resonanten Tunneleffekt bewirken, die Leitungskanäle also entkoppelt sind.

Fig. 5 zeigt eine schematische Darstellung einer zweiten Variante 100" des Zweikanal-Halbleiterbauelements der Fig. 1 mit selektiver Kontaktierung, bei der also eine Source-Elektrode 118 im entkoppelten Zustand nur mit dem ersten Leitungskanal 102.1, und eine Drain-Elektrode 120 im entkoppelten Zustand nur mit dem zweiten Leitungskanal 102.2 verbunden ist. Nur bei geeignet angelegten Steuerspannungen UG1 und UG2 zur Einstellung eines resonanten Tunneleffekts kann also hier zwischen der Source-Elektrode 108 und der Drain-Elektrode 110 ein Ladungsträgerstrom fließen.

Fig. 6 zeigt eine schematische Darstellung einer dritten Variante 100‴ des Zweikanal-Halbleiterbauelements der Fig. 1, welche als Vierpol-Bauelement ausgebildet ist. Jeweils zwei voneinander elektrisch getrennt ansteuerbare Source- Elektroden 128.1 und 128.2 und zwei voneinander elektrisch getrennt ansteuerbare Drain-Elektroden 130.1 und 130.2 erlauben eine getrennte Ansteuerung der Leitungskanäle 102.1 und 102.2 in unterschiedlichen Fall-Konstellationen. Diese werden weiter untern näher erläutert.

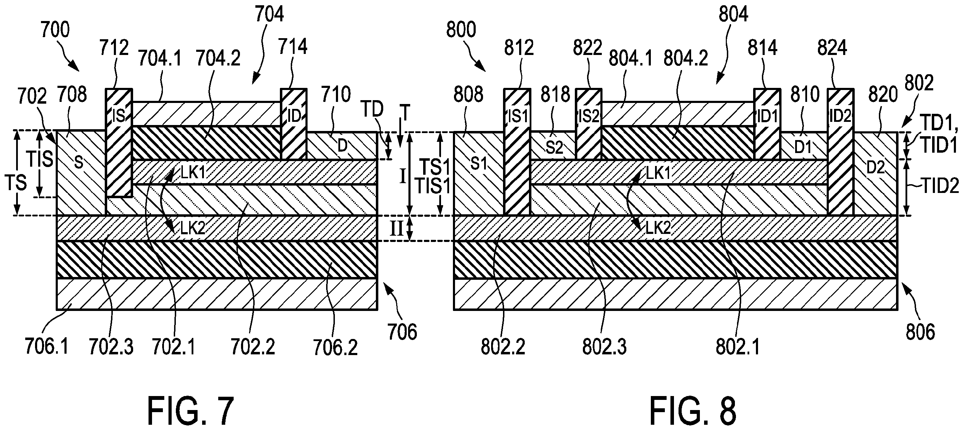

Fig. 7 zeigt eine schematische Querschnittsansicht eines Zweikanal-Halbleiterbauelements 700, das eine selektive Kontaktierung jeweils einer Source-oder Drain-Elektrode zur getrennten Ansteuerung von zwei Leitungskanälen vorsieht, entsprechend der in Fig. 5 dargestellten Variante. Diese Art der Kontaktierung wird hier auch als "diagonale Kontaktierung" bezeichnet. Nachfolgend wird die Struktur des Zweikanal-Halbleiterbauelements 700 erläutert.

Das Zweikanal-Halbleiterbauelement 700 hat einen p-dotierten Siliziumkörper 702, auf dem oberseitig Top-Gate-Elektrode 704 und unterseitig eine Bottom-Gate-Elektrode 706 angeordnet sind. Die Top-Gate-Elektrode 704 ist aus einer elektrisch leitfähigen Schicht 704.1 auf einer oberen Gate-Isolationsschicht 704.2 aus dielektrischem Material aufgebaut. Die Gate-Isolationsschicht 704.2 liegt auf der hierfür strukturierten Oberseite des Siliziumkörpers 702 auf. Der Siliziumkörper 702 ist lateral strukturiert, wie weiter unten näher erläutert wird. Die Bottom-Gate-Elektrode 706 ist aus einer elektrisch leitfähigen Schicht 706.1 auf einer unteren Gate-Isolationsschicht 706.2 aus dielektrischem Material aufgebaut. Die untere Gate-Isolationsschicht 706.2 liegt auf der Unterseite des Siliziumkörpers 102 auf und erstreckt sich lateral über die gesamte Unterseite des Siliziumkörpers 702. Auch die auf der unteren Gate-Isolationsschicht 706.2 aufliegende elektrisch leitfähige Schicht 706.1 erstreckt sich lateral über die gesamte Unterseite des Siliziumkörpers 702.

Eine Source-Elektrode hat ein im Siliziumkörper 702 ausgebildetes dotiertes Source-Gebiet 708 vom n-Leitfähigkeitstyp. Weitere Strukturelemente der Source-Elektrode, insbesondere zur Kontaktierung des Source-Gebiets, sind der Einfachheit der Darstellung halber in Fig. 7 nicht gezeigt. Sie können nach bekannten Verfahren der CMOS-Technologie hergestellt werden.

Eine Drain-Elektrode hat ein im Siliziumkörper 702 ausgebildetes dotiertes Drain-Gebiet 710 vom n-Leitfähigkeitstyp.

Wie in Fig. 7 deutlich zu erkennen ist, hat das Source-Gebiet 708 in Tiefenrichtung T eine größere Tiefenerstreckung TS im Siliziumkörper 702 als das Draingebiet 710, das also eine geringere Tiefenerstreckung TD hat. Die Tiefenerstreckung TD entspricht in etwa der für die verwendete CMOS-Technologie üblichen Dotierungstiefe eines Source-/Drain-Gebiets. Die im Vergleich größere Tiefenerstreckung TS des Source-Gebiets 708 gliedert den Siliziumkörper 702 für die Zwecke der nachfolgenden Erläuterung in einen ersten Tiefenabschnitt I, der von der Oberfläche des Siliziumkörpers 702 bis zu einer Unterkante des Source-Gebiets 708 reicht, also der Tiefenerstreckung TS des Source-Gebiets entspricht, und in einen zweiten Tiefenabschnitt II, der sich in der Tiefenrichtung T an den ersten Tiefenabschnitt I anschließend bis zur Unterseite des Siliziumkörpers 702 erstreckt. Auf der Unterseite des Siliziumkörpers 702 liegt wie erläutert die untere Gate-Isolationsschicht 706.2 auf, die somit nicht zum Siliziumkörper 702 zu zählen ist.

Im Folgenden wird die Struktur der Top-Gate-Elektrode 704 in ihrem Umfeld näher erläutert. Lateral gesehen zwischen dem Source-Gebiet 708 und der Top-Gate-Elektrode 704 ist ein Source-Isolationsgebiet 712 angeordnet, welches das Source-Gebiet 708 und die Top-Gate-Elektrode 704 voneinander elektrisch isoliert. Eine Tiefenerstreckung TIS des Source-Isolationsgebiets 712 reicht in den ersten Tiefenabschnitt I des Siliziumkörpers hinein und über die Tiefenerstreckung TS des Drain-Gebiets 710 hinaus, erreicht jedoch nicht in zweiten Tiefenabschnitt II. Das Source-Isolationsgebiet hat somit eine Tiefenerstreckung TIS, die größer ist als die des Drain-Gebiets 710, aber kleiner als die des Source-Gebiets 708.

Lateral gesehen zwischen dem ersten Drain-Gebiet 710 und der Top-Gate-Elektrode 704 ist ein Drain-Isolationsgebiet 714 angeordnet, welches das Drain-Gebiet 710 (und mit ihm die gesamte Drain-Elektrode) und die Top-Gate-Elektrode 704 voneinander elektrisch isoliert. Das Drain-Isolationsgebiet 714 reicht mit seiner Tiefenerstreckung TID in der Tiefenrichtung T bis zur Unterkante der Gate-Isolationsschicht, und ebenso bis zur Unterkante des Drain-Gebiets 710. Die Gate-Isolationsschicht ist also in einer im Siliziumkörper 702 ausgebildeten Vertiefung angeordnet.

Die Ausmaße des Source-Gebiets 708, des Draingebiets 710, des Source-Isolationsgebiet 712 und des Drain-Isolationsgebiets 714 in Tiefenrichtung sind so gewählt, dass im Betrieb des Zweikanal-Halbleiterbauelements bei geeigneten Steuerspannungen UG1 und UG2 (vgl. Fig. 1) an der Top-Gate-Elektrode 704 und an der Bottom-Gate-Elektrode 706 im Siliziumkörper 702 unterhalb der Top-Gate-Elektrode 704 ein erster Leitungskanal 702.1 und oberhalb der Bottom-Gate-Elektrode 706 ein vom ersten Leitungskanal 702.1 getrennter zweiter Leitungskanal 702.2 ausbilden. Die beiden Leitungskanäle 702.1 und 702.2 sind voneinander durch einen sich bei geeigneter Wahl der Gate-Spannungen ergebenden Barriere-Bereich 702.3 des Siliziumkörpers 702 getrennt sind.

Wenn die Top-Gate-Elektrode 704 und die Bottom-Gate-Elektrode 706 mit jeweiligen geeigneten ersten und zweiten Betriebsspannungen UG1 und UG2 beaufschlagt sind, bildet sich also im ersten Tiefenabschnitt I der erster, lateral vom Source-Gebiet 708 durch das Source-Isolationsgebiet 712 getrennter Leitfähigkeitskanal 702.1 vom n-Leitfähigkeitstyp aus. Seine Tiefenerstreckung ist mit der an die Top-Gate-Elektrode 704 angelegten Steuerspannung UG1 beeinflussbar. Dieser Leitfähigkeitskanal 702.1 hat keinen unmittelbaren Kontakt zum Source-Gebiet 708, weil er in der Tiefenrichtung T nicht bis an die Unterkante des Source-Isolationsgebiets 712 reicht, sondern im Siliziumkörper 702 etwas weiter oben endet. Somit grenzt das n-dotierte Source-Gebiet 708 lateral unterhalb des Source-Isolationsgebiets 712 an den Barriere-Bereich 702.3 des p-dotierten Siliziumkörpers. Die dadurch entstehende Sperrzone an der Grenzfläche zwischen dem Siliziumkörper 702 und dem Source-Gebiet 708 können Ladungsträger im Betrieb nicht passieren.

Weiterhin bildet sich in diesem Zustand, wenn die Top-Gate-Elektrode 704 und die Bottom-Gate-Elektrode 706 mit den genannten ersten und zweiten Betriebsspannungen UG1 und UG2 beaufschlagt sind, im zweiten Tiefenabschnitt II des Siliziumkörpers 702 ein zweiter Leitfähigkeitskanal 702.3 vom n-Leitfähigkeitstyp aus. Seine Tiefenerstreckung ist mit der an die Bottom-Gate-Elektrode 706 angelegten Steuerspannung UG2 beeinflussbar. Genauer gesagt beeinflusst die an der Bottom-Gate-Elektrode 706 anliegende Spannung also, wie weit sich der zweite Leitfähigkeitskanal 702.2 von der Unterseite des Siliziumkörper 702 aus "nach oben" in Richtung der Oberseite des Siliziumkörpers erstreckt. Die zweite Betriebsspannung UG2 ist so gewählt, dass sich der zweite Leitfähigkeitskanal nur unterhalb des Source-Gebiets 708 ausbildet, jedoch vorzugsweise bis unmittelbar an die Unterkante des Source-Gebiets 708 heranreicht.

Es lassen sich, je nach gewählten Betriebsspannungen UG1 und UG2 insbesondere die folgenden Betriebszustände einstellen:
a) in einem ersten Betriebszustand, in welchem die Top-Gate-Elektrode 704 und die Bottom-Gate-Elektrode 706 mit jeweiligen ersten und zweiten Betriebsspannungen beaufschlagt sind, bildet sich im ersten Tiefenabschnitt ein erster, lateral vom Source-Gebiet 708 durch das Source-Isolationsgebiet 712 getrennter Leitfähigkeitskanal 702.1 aus und im zweiten Tiefenabschnitt ein zweiter Leitfähigkeitskanal 702.2, der vom ersten Leitfähigkeitskanal durch ein sich in Tiefenrichtung zwischen den Leitfähigkeitskanälen erstreckendes Barrieregebiet 702.3 des Siliziumkörpers 702 entkoppelt ist. Dieser Betriebszustand entspricht dem in Fig. 3 dargestellten Zustand. In diesem Betriebszustand können keine Ladungsträger zwischen dem Source-Gebiet 708 und dem Drain-Gebiet fließen 710.
b) in einem zweiten Betriebszustand, in welchem die Top-Gate-Elektrode 704 und die Bottom-Gate-Elektrode 706 mit dritten und vierten Betriebsspannungen beaufschlagt sind, die eine Resonanzbedingung erfüllen, sind der erste und zweite Leitfähigkeitskanal 702.1 und 702.2 mittels eines Tunneleffekts für Elektronen über das Barrieregebiet 702.3 des Siliziumkörpers hinweg miteinander gekoppelt. Nur im zweiten Betriebszustand also können Ladungsträger zwischen dem Source-Gebiet 708 und dem Drain-Gebiet 710 fließen, und zwar durch den zweiten Leitfähigkeitskanal 702.2, per Tunneleffekt durch das Barrieregebiet 702.3 und durch den ersten Leitfähigkeitskanal 702.1.

Auf diese Weise bildet das Zweikanal-Halbleiterbauelement 700 einen steuerbaren Schalter. Er zeichnet sich dadurch aus, dass bei Vorhandensein einer scharfen Resonanz die Umschaltung mit sehr kleinen Spannungsveränderungen an den Steuerspannungen erzielt werden kann. Damit werden zum einen kleine Schaltströme mit geringen Verlustleistungen, d. h. mit kleiner Erwärmung erreicht, und zum anderen besonders kurze Schaltzeiten.

Die Struktur des Halbleiterbauelements ist für die Integration in bestehende CMOS-Technologien geeignet und entsprechend skalierbar. Zu seiner Herstellung ist vorteilhafterweise ein SOI-Wafer verwendbar. Die Materialwahl für die einzelnen Schichten, insbesondere der Gate-Elektroden der Isolator-Schichten etc. kann entsprechend einer jeweils angewandten CMOS-Technologie erfolgen. Sie ist daher insbesondere von der mit der jeweiligen CMOS-Technologie erreichten Skalierung, also von den technologieabhängigen minimalen Strukturbreiten bestimmt.

Fig. 8 zeigt eine schematische Querschnittsansicht eines als Vierpol-Bauelement ausgebildeten Zweikanal-Halbleiterbauelements 800 mit selektiver Kontaktierung jeweils beider Source- und Drain-Elektroden zur getrennten Ansteuerung der Leitungskanäle.

Das Zweikanal-Halbleiterbauelement 800 hat einen p-dotierten Siliziumkörper 802, auf dem oberseitig Top-Gate-Elektrode 804 und unterseitig eine Bottom-Gate-Elektrode 806 angeordnet sind. Die Top-Gate-Elektrode 804 ist aus einer elektrisch leitfähigen Schicht 804.1 auf einer oberen Gate-Isolationsschicht 804.2 aus dielektrischem Material aufgebaut. Die Gate-Isolationsschicht 804.2 liegt auf der hierfür strukturierten Oberseite des Siliziumkörpers 802 auf. Der Siliziumkörper 802 ist lateral strukturiert, wie weiter unten näher erläutert wird. Die Bottom-Gate-Elektrode 806 ist aus einer elektrisch leitfähigen Schicht 806.1 auf einer unteren Gate-Isolationsschicht 806.2 aus dielektrischem Material aufgebaut. Die untere Gate-Isolationsschicht 806.2 liegt auf der Unterseite des Siliziumkörpers 802 auf und erstreckt sich lateral über die gesamte Unterseite des Siliziumkörpers 802. Auch die auf der unteren Gate-Isolationsschicht 806.2 aufliegende elektrisch leitfähige Schicht 786.1 erstreckt sich lateral über die gesamte Unterseite des Siliziumkörpers 802.

Eine erste Source-Elektrode hat ein im Siliziumkörper 802 ausgebildetes dotiertes erstes Source-Gebiet 808 vom n-Leitfähigkeitstyp. Weitere Strukturelemente der Source-Elektrode, insbesondere zur Kontaktierung des Source-Gebiets, sind der Einfachheit der Darstellung halber in Fig. 8 nicht gezeigt. Sie können nach bekannten Verfahren der CMOS-Technologie hergestellt werden.

Eine erste Drain-Elektrode hat ein im Siliziumkörper 802 ausgebildetes dotiertes Drain-Gebiet 810 vom n-Leitfähigkeitstyp.

Zusätzlich zu diesen auch im Zweikanal-Bauelement 700 der Fig. 7 enthaltenen Strukturelementen hat das Ausführungsbeispiel der Fig. 8 ein zweites Source-Gebiet 818. Dieses zweite Source-Gebiet 818 ist lateral zwischen dem ersten Source-Gebiet 808 und der Top-Gate-Elektrode 804 angeordnet. Das zweite Source-Gebiet 818 hat eine geringere Tiefenerstreckung als das erste Source-Gebiet 808. Die Tiefenerstreckung entspricht hier der des ersten Draingebiets 810.

Auch ein zweites Drain-Gebiet 820 ist vorhanden. Dieses ist lateral entfernter als das erste Drain-Gebiet 810 von der Top-Gate-Elektrode 804 angeordnet. Das zweite Drain-Gebiet 820 hat eine größere Tiefenerstreckung als das erste Drain-Gebiet 810. Die Tiefenerstreckung des zweiten Drain-Gebiets 820 entspricht der des ersten Source-Gebiets 808.

Das zweite Source-Gebiet 818 ist vom ersten Source-Gebiet 808 lateral durch das erste Source-Isolationsgebiet 812 elektrisch isoliert. Dessen Tiefenerstreckung reicht hier, anders als im Ausführungsbeispiel der Fig. 7, bis zur Unterkante des ersten Source-Gebiets 808. Von der Top-Gate-Elektrode 804 ist das zweite Source-Gebiet 818 lateral durch ein zweites Source-Isolationsgebiet 822 elektrisch isoliert.

Das zweite Drain-Gebiet 820 ist vom ersten Drain-Gebiet lateral durch ein zweites Drain-Isolationsgebiet 824 elektrisch isoliert. Das zweite Drain-Isolationsgebiet erstreckt sich in den zweiten Tiefenabschnitt II hinein und hat dieselbe Tiefenerstreckung wie das erste Source-Isolationsgebiet 812.

Wie in Fig. 8 deutlich zu erkennen ist, hat das erste Source-Gebiet 808 in Tiefenrichtung T eine größere Tiefenerstreckung TS1 im Siliziumkörper 802 als das erste Draingebiet 810, das also eine geringere Tiefenerstreckung TD1 hat. Die Tiefenerstreckung TD1 entspricht in etwa der für die verwendete CMOS-Technologie üblichen Dotierungstiefe eines Source-/Drain-Gebiets.

Im Folgenden wird die Struktur der Top-Gate-Elektrode 804 in ihrem Umfeld näher erläutert.

Lateral gesehen zwischen dem zweiten Source-Gebiet 818 und der Top-Gate-Elektrode 804 ist das schon erwähnte zweite Source-Isolationsgebiet 822 angeordnet, welches das zweite Source-Gebiet 818 und die Top-Gate-Elektrode 804 voneinander elektrisch isoliert. Eine Tiefenerstreckung TIS2 des zweiten Source-Isolationsgebiets 822 in den ersten Tiefenabschnitt I des Siliziumkörpers hinein entspricht der Tiefenerstreckung des ersten Drain-Isolationsgebiets 814 und reicht bis zur Unterkante der Gate-Isolationsschicht 804.2.

Lateral gesehen zwischen dem ersten Drain-Gebiet 810 und der Top-Gate-Elektrode 804 ist ein erstes Drain-Isolationsgebiet 814 angeordnet, welches das erste Drain-Gebiet 810 (und mit ihm die gesamte Drain-Elektrode) und die Top-Gate-Elektrode 804 voneinander elektrisch isoliert. Das erste Drain-Isolationsgebiet 814 reicht mit seiner Tiefenerstreckung TID1 in der Tiefenrichtung T bis zur Unterkante der Gate-Isolationsschicht 804.2, und ebenso bis zur Unterkante des ersten Drain-Gebiets 810. Die Gate-Isolationsschicht 804.2 ist also in einer im Siliziumkörper 802 ausgebildeten Vertiefung angeordnet.

Das erste Drain-Gebiet 810 und das zweite Drain-Gebiet 820 sind durch ein zweites Drain-Isolationsgebiet 824 voneinander elektrisch isoliert. Die Tiefenerstreckung TID2 des zweiten Drain-Isolationsgebiets im Siliziumkörper 702 entspricht der des zweiten Drain-Gebiets 820, des ersten Source-Gebiets 808 und des ersten Source-Isolationsgebiets 812, reicht also bis zur Oberkante des zweiten Tiefenabschnitts II.

Die Ausmaße der ersten und zweiten Source-Gebiete 808, 818, der ersten und zweiten Draingebiete 810, 820, der ersten und zweiten Source-Isolationsgebiete 812, 822 und der ersten und zweiten Drain-Isolationsgebiete 814, 824 in Tiefenrichtung sind so gewählt, dass im Betrieb des Zweikanal-Halbleiterbauelements bei geeigneten Steuerspannungen UG1 und UG2 an der Top-Gate-Elektrode 804 und an der Bottom-Gate-Elektrode 806 im Siliziumkörper 802 unterhalb der Top-Gate-Elektrode 804 ein erster Leitungskanal 802.1 und oberhalb der Bottom-Gate-Elektrode 806 ein vom ersten Leitungskanal 802.1 getrennter zweiter Leitungskanal 802.2 ausbilden. Die beiden Leitungskanäle 802.1 und 802.2 sind voneinander durch einen sich bei geeigneter Wahl der Gate-Spannungen ergebenden Barriere-Bereich 802.3 des Siliziumkörpers 802 getrennt.

Wenn die Top-Gate-Elektrode 804 mit einer geeigneten ersten Betriebsspannungen UG1 beaufschlagt ist, bildet sich also im ersten Tiefenabschnitt I der erster, lateral vom ersten Source-Gebiet 808 durch das Source-Isolationsgebiet 812 getrennter Leitfähigkeitskanal 802.1 vom n-Leitfähigkeitstyp aus. Seine Tiefenerstreckung ist mit der an die Top-Gate-Elektrode 804 angelegten Steuerspannung UG1 beeinflussbar. Dieser Leitfähigkeitskanal 802.1 hat keinen unmittelbaren Kontakt zum ersten Source-Gebiet 808, weil er in der Tiefenrichtung T nicht bis an die Unterkante des Source-Isolationsgebiets 812 reicht. Der erste Leitfähigkeitskanal 802.1 stellt jedoch bei geeigneter Beschaltung eine leitfähige Verbindung zwischen dem zweiten Source-Gebiet 818 und dem ersten Drain-Gebiet 810 her. So kann bei Bedarf der erste Leitfähigkeitskanal 802.1 als einziger Leitfähigkeitskanal des Bauelements betrieben werden.

Weiterhin bildet sich, wenn die Bottom-Gate-Elektrode 806 mit einer geeigneten zweiten Betriebsspannung UG2 beaufschlagt ist, im zweiten Tiefenabschnitt II des Siliziumkörpers 802 ein zweiter Leitfähigkeitskanal 802.3 vom n-Leitfähigkeitstyp aus. Seine Tiefenerstreckung ist mit der an die Bottom-Gate-Elektrode 806 angelegten Steuerspannung UG2 beeinflussbar. Genauer gesagt beeinflusst die an der Bottom-Gate-Elektrode 806 anliegende Spannung also, wie weit sich der zweite Leitfähigkeitskanal 802.2 von der Unterseite des Siliziumkörper 802 aus "nach oben" in Richtung der Oberseite des Siliziumkörpers erstreckt. Die zweite Betriebsspannung UG2 ist so gewählt, dass sich der zweite Leitfähigkeitskanal nur unterhalb des ersten Source-Gebiets 808 ausbildet, jedoch vorzugsweise bis unmittelbar an die Unterkante des Source-Gebiets 808 heranreicht. Der zweite Leitfähigkeitskanal 802.2 stellt bei geeigneter Beschaltung eine leitfähige Verbindung zwischen dem ersten Source-Gebiet 808 und dem zweiten Drain-Gebiet 820 her. So kann bei Bedarf der zweite Leitfähigkeitskanal 802.2 als einziger Leitfähigkeitskanal des Bauelements betrieben werden.

Die Leitfähigkeitskanäle 802.1 und 802.2 können also unabhängig voneinander gesteuert werden. Es können jedoch auch beide Leitfähigkeitskanäle 802.1 und 802.2 parallel betrieben werden.

Es lassen sich weiterhin, insbesondere je nach gewählten Betriebsspannungen UG1 und UG2 die folgenden Betriebszustände einstellen:
Wenn die Top-Gate-Elektrode 804 und die Bottom-Gate-Elektrode 806 mit jeweiligen ersten und zweiten Betriebsspannungen beaufschlagt sind, bildet sich im ersten Tiefenabschnitt I ein erster, lateral vom Source-Gebiet 808 durch das erste Source-Isolationsgebiet 812 und vom zweiten Draingebiet durch das zweite Drain-Isolations-Gebiet 824 getrennter Leitfähigkeitskanal 802.1, der das zweite Source-Gebiet 818 mit dem ersten Drain-Gebiet 810 elektrisch verbindet. Im zweiten Tiefenabschnitt bildet sich ein zweiter Leitfähigkeitskanal 802.2, der vom ersten Leitfähigkeitskanal durch ein sich in Tiefenrichtung zwischen den Leitfähigkeitskanälen erstreckendes Barrieregebiet 802.3 des Siliziumkörpers 802 entkoppelt ist. Der zweite Leitfähigkeitskanal verbindet das erste Source-Gebiet 818 mit dem zweiten Drain-Gebiet 820.

Erfüllen die Betriebsspannung UG1 und UG2 eine einstellbare Resonanzbedingung nicht, entspricht dieser Betriebszustand dem in Fig. 3 dargestellten entkoppelten Zustand. Ladungsträgerströme durch die genannten beiden Leitfähigkeitskanäle können jedoch individuell gesteuert werden.

Erfüllen die Betriebsspannung UG1 und UG2 die einstellbare Resonanzbedingung, sind der erste und zweite Leitfähigkeitskanal 802.1 und 802.2 mittels eines Tunneleffekts für Elektronen über das Barrieregebiet 802.3 des Siliziumkörpers hinweg miteinander gekoppelt. Es können dann also auch Ladungsträger zwischen dem ersten Source-Gebiet 808 und dem zweiten Drain-Gebiet 810 fließen, und zwischen dem zweiten Source-Gebiet 818 und dem zweiten Drain-Gebiet 820, und zwar jeweils durch den zweiten Leitfähigkeitskanal 802.2, per Tunneleffekt durch das Barrieregebiet 802.3 und durch den ersten Leitfähigkeitskanal 802.1.

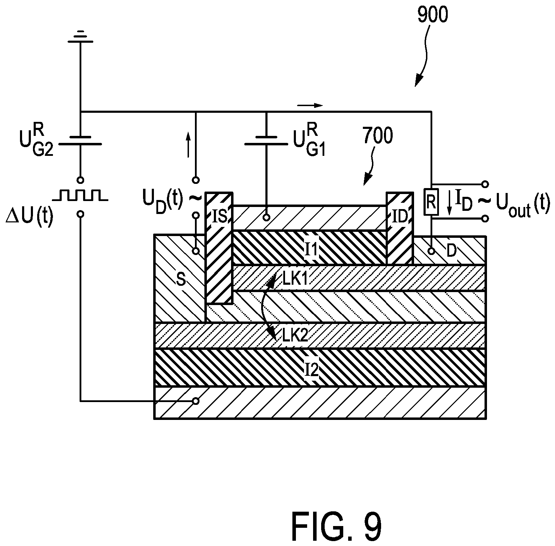

Fig. 9 zeigt eine schematische Querschnittsansicht des Zweikanal-Halbleiterbauelements 700 aus Fig. 7 mit Verschaltung zur Bildung eines Signalmischers 900.

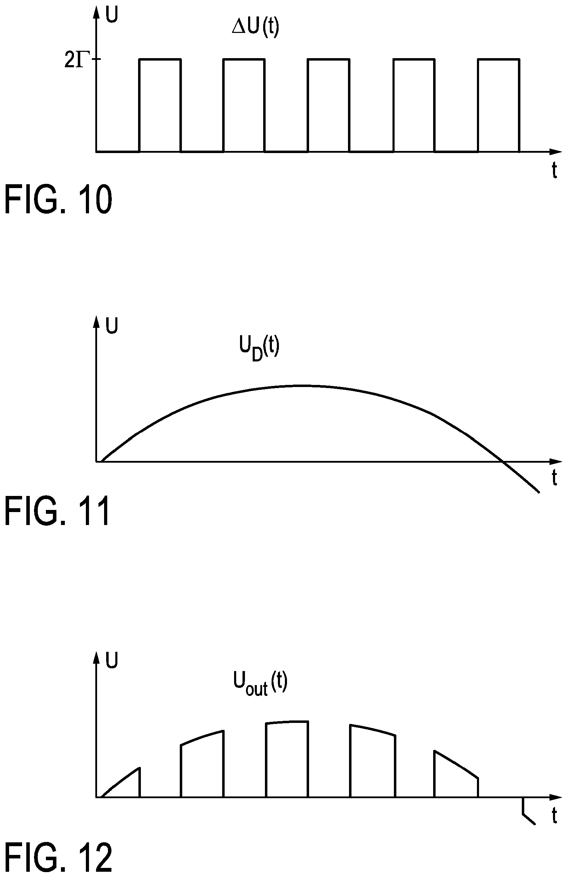

Der Signalmischer 900 ist wie folgt verschaltet:
Der Drain-Strom I_{D} am Ausgang des Signalmischers 900 wird zum einen von einem eingangsseitigen Hochfrequenzsignal *U_{D}*(*t*) an der Source-Elektrode und von einer lokalen Oszillator-Spannung Δ*U*(*t*) an der Bottom-Gate-Elektrode gesteuert. Über einen Widerstand R kann an der Drain-Elektrode eine Ausgangsspannung *Uₒᵤₜ*(*t*) abgegriffen werden, die dem Produkt des Hochfrequenzsignals *U_{D}(t)* an der Source-Elektrode und der lokalen Oszillator-Spannung Δ*U*(*t*) entspricht. Die Figuren 10 bis 12 zeigen dazu passende Beispielsignale. Fig. 10 zeigt ein Signalbeispiel einer lokalen Oszillator-Spannung Δ*U*(*t*) als Funktion der Zeit in Form eines Rechtecksignals, die dem Signalmischer der Fig. 9 über seine Bottom-Gate-Elektrode zugeführt werden kann. Fig. 11 zeigt ein Signalbeispiel eines Hochfrequenzsignals *U_{D}(t)* als Funktion der Zeit, das parallel dem Signalmischer der Fig. 9 über die Source-Elektrode zugeführt werden kann. Fig. 12 zeigt das sich ergebende Ausgangssignal, das dem Produkt der beiden Eingangssignale der Figuren 10 und 11 entspricht. Das Signal des lokalen Oszillators schaltet den Signalmischer in periodischer Folge leitend und nichtleitend, so dass das ausgegebene Signal dem Produkt des lokalen Oszillatorsignals mit dem Eingangssignal entspricht.

Ein solcher Signalmischer eignet besonders sich für den Einsatz in Hochfrequenzschaltungen, insbesondere Sender- und Empfängerschaltungen bei der Übertragung von Funksignalen oder optischen Signalen mit Hilfe von Trägerwellen.

Zusammenfassend wurden Ausführungsbeispiele eines Zweikanal-Halbleiterbauelement beschrieben. Dieses hat einen dotierten Halbleiterkörper aus einem Gruppe-IV-Halbleitermaterial, eine oberseitige Top-Gate-Elektrode und eine unterseitige Bottom-Gate-Elektrode. Ein Source-Gebiet hat eine größere Tiefenerstreckung im Siliziumkörper hat als ein Draingebiet. Zwischen einem Source-Gebiet und der Top-Gate-Elektrode ist ein Source-Isolationsgebiet angeordnet, und zwischen einem Drain-Gebiet und der Top-Gate-Elektrode ist ein Drain-Isolationsgebiet angeordnet, welches sich in Tiefenrichtung bis zur Unterkante einer Gate-Isolationsschicht der Top-Gate-Elektrode erstreckt. In einem ersten Betriebszustand ist ein erster, lateral vom Source-Gebiet durch das Source-Isolationsgebiet getrennter Leitfähigkeitskanal ausbildbar, und ein zweiter Leitfähigkeitskanal, der vom ersten Leitfähigkeitskanal durch ein sich in Tiefenrichtung zwischen den Leitfähigkeitskanälen erstreckendes Barrieregebiet des Halbleiterkörpers entkoppelt ist. In einem zweiten Betriebszustand, der eine Resonanzbedingung erfüllt, sind der erste und zweite Leitfähigkeitskanal mittels eines Tunneleffekts für Minoritätsladungsträger über das Barrieregebiet des Halbleiterkörpers hinweg miteinander koppelbar.

## Patentansprüche

1. Zweikanal-Halbleiterbauelement (100), umfassend
- einen dotierten Halbleiterkörper (102) eines ersten Leitfähigkeitstyps aus einem Gruppe-IV-Halbleitermaterial;
- eine oberseitige Top-Gate-Elektrode (104, 704, 804);
- eine unterseitige Bottom-Gate-Elektrode (106, 706, 806),
- eine erste Source-Elektrode (108) mit einem im Halbleiterkörper (102) ausgebildeten dotierten ersten Source-Gebiet (708, 808) eines zweiten, dem ersten Leitfähigkeitstyp entgegengesetzten Leitfähigkeitstyps,
- eine erste Drain-Elektrode (110) mit einem im Halbleiterkörper (102) ausgebildeten dotierten ersten Drain-Gebiet (710, 810) des zweiten Leitfähigkeitstyps, wobei
- das erste Source-Gebiet (708, 808) eine größere Tiefenerstreckung im Halbleiterkörper (102) hat als das erste Draingebiet (710, 810) und den Halbleiterkörper (102) gliedert in einen ersten Tiefenabschnitt, der bis zu einer Unterkante des ersten Source-Gebiets (708, 808) reicht, und in einen zweiten Tiefenabschnitt, der sich in Tiefenrichtung an den ersten Tiefenabschnitt anschließend bis zur Unterseite des Halbleiterkörpers erstreckt;
- lateral gesehen zwischen dem ersten Source-Gebiet (708, 808) und der Top-Gate-Elektrode (804) ein erstes Source-Isolationsgebiet (712, 812) angeordnet ist, welches die Source-Elektrode (108) und die Top-Gate-Elektrode (804) voneinander elektrisch isoliert und welches sich in Tiefenrichtung in den ersten Tiefenabschnitt des Halbleiterkörpers, nicht jedoch in den zweiten Tiefenabschnitt hinein erstreckt;
- lateral gesehen zwischen dem ersten Drain-Gebiet (710, 810) und der Top-Gate-Elektrode (804) ein erstes Drain-Isolationsgebiet (714, 814) angeordnet ist, welches die Drain-Elektrode (110) und die Top-Gate-Elektrode (804) voneinander elektrisch isoliert und welches sich in Tiefenrichtung bis zur Unterkante einer Gate-Isolationsschicht der Top-Gate-Elektrode (804) erstreckt; wobei
- jeweilige Ausmaße des ersten Source-Gebiets (808), des ersten Draingebiets (810), des ersten Source-Isolationsgebiet (812) und des ersten Drain-Isolationsgebiets (814) in Tiefenrichtung so gewählt sind, dass
- in einem ersten Betriebszustand, in welchem die Top-Gate-Elektrode (804) und die Bottom-Gate-Elektrode (806) mit jeweiligen ersten und zweiten Betriebsspannungen beaufschlagt sind, im ersten Tiefenabschnitt ein erster, lateral vom ersten Source-Gebiet (808) durch das erste Source-Isolationsgebiet (812) getrennter erster Leitfähigkeitskanal (702.1,802.1) des zweiten Leitfähigkeitstyps ausbildbar ist und im zweiten Tiefenabschnitt ein zweiter Leitfähigkeitskanal (702.2, 802.2) des zweiten Leitfähigkeitstyps ausbildbar ist, der vom ersten Leitfähigkeitskanal (702.1, 802.1) durch ein sich in Tiefenrichtung zwischen den Leitfähigkeitskanälen erstreckendes Barrieregebiet des Halbleiterkörpers entkoppelt ist, und
- in einem zweiten Betriebszustand, in welchem die Top-Gate-Elektrode (804) und die Bottom-Gate-Elektrode (806) mit dritten und vierten Betriebsspannungen beaufschlagt sind, die eine Resonanzbedingung erfüllen, der erste und zweite Leitfähigkeitskanal (702.1, 702.2) mittels eines Tunneleffekts für Minoritätsladungsträger über das Barrieregebiet des Halbleiterkörpers hinweg miteinander koppelbar sind.

2. Zweikanal-Halbleiterbauelement (100) nach Anspruch 1, bei dem die Leitfähigkeitskanäle (702.1, 702.2) eine Kanallänge von zwischen 5 und 30 nm haben.

3. Zweikanal-Halbleiterbauelement (100) nach Anspruch 1 oder 2, bei dem das Barrieregebiet eine Ausdehnung in Tiefenrichtung von zwischen 10 und 30 nm hat.

4. Zweikanal-Halbleiterbauelement (100) nach einem der vorstehenden Ansprüche, mit
- einem zweiten Source-Gebiet (818), welches lateral zwischen dem ersten Source-Gebiet (808) und der Top-Gate-Elektrode (704, 804) angeordnet ist, eine geringere Tiefenerstreckung hat als das erste Source-Gebiet (808) und von diesem lateral durch das erste Source-Isolationsgebiet (812) elektrisch isoliert ist, und welches von der der Top-Gate-Elektrode (704, 804) lateral durch ein zweites Source-Isolationsgebiet (822) elektrisch isoliert ist,
- einem zweiten Drain-Gebiet (820), welches lateral entfernter als das erste Drain-Gebiet (810) von der Top-Gate-Elektrode (804) angeordnet ist, eine größere Tiefenerstreckung hat als das erste Drain-Gebiet (810) und von diesem lateral durch ein zweites Drain-Isolationsgebiet (824) elektrisch isoliert ist und das sich in den zweiten Tiefenabschnitt hineinerstreckt,
- wobei jeweilige Ausmaße des ersten und zweiten Source-Gebiets (808, 818), des ersten und zweiten Draingebiets (810, 820), des ersten und zweiten Source-Isolationsgebiet (812, 822) und des ersten und zweiten Drain-Isolationsgebiets (814, 824) in Tiefenrichtung so gewählt sind, dass sich der erste Leitfähigkeitskanal (702.1, 802.1) in lateraler Richtung zwischen dem zweiten Source-Gebiet (818) und dem ersten Drain-Gebiet (810) erstreckt und der zweite Leitfähigkeitskanal (702.2, 802.2) sich in der lateralen Richtung zwischen dem ersten Source-Gebiet (808) und dem zweiten Draingebiet (820) erstreckt.

5. Signalmischer, umfassend ein Zweikanal-Halbleiterbauelement (100) nach einem der vorstehenden Ansprüche, dem über die Bottom-Gate-Elektrode (706) ein erstes Eingangssignal zugeführt ist, dem über die Source-Elektrode (108) ein zweites Eingangssignal zugeführt ist, und an dessen Drain-Elektrode (110) über einen Ausgangswiderstand ein Ausgangssignal abgreifbar ist.

6. Detektorbauelement für elektromagnetische Wellen, umfassend ein Zweikanal-Halbleiterbauelement nach einem der Ansprüche 1 bis 3.

## Claims

1. Two-channel semiconductor component (100), comprising
- a doped semiconductor body (102) of a first conductivity type formed from a group IV semiconductor material;
- a top-side top-gate electrode (104, 704, 804);
- a bottom-side bottom-gate electrode (106, 706, 806),
- a first source electrode (108) with a doped first source region (708, 808) which is of a second conductivity type opposite to the first conductivity type and which is formed in the semiconductor body (102),
- a first drain electrode (110) with a doped first drain region (710, 810) of the second conductivity type formed in the semiconductor body (102), wherein
- the first source region (708, 808) has a greater depth extent in the semiconductor body (102) than the first drain region (710, 810) and divides the semiconductor body (102) into a first depth section that extends as far as a lower edge of the first source region (708, 808), and a second depth region that extends in the depth direction adjacent to the first depth section as far as the bottom side of the semiconductor body;
- from a lateral point of view, a first source isolation region (712, 812) is arranged between the first source region (708, 808) and the top-gate electrode (804), wherein said first source isolation region electrically isolates the first source electrode (108) and the top-gate electrode (804) from each other and extends in the depth direction into the first depth section of the semiconductor body, but not into the second depth section;
- from a lateral point of view, between the first drain region (710, 810) and the top-gate electrode (804), a first drain isolation region (714, 814) is arranged which electrically isolates the drain electrode (110) and the top-gate electrode (804) from each other and extends in the depth direction as far as the lower edge of a gate isolation layer of the top-gate electrode (804); wherein
- respective depth direction dimensions of the first source region (808), of the first drain region (810), of the first source isolation region (812) and of the first drain isolation region (814) are chosen such that
- in a first operating state in which respective first and second operating voltages are applied to the top-gate electrode (804) and the bottom-gate electrode (806), a first conductive channel (702.1, 802.1) of the second conductivity type, which is separated laterally from the first source region (808) by the first source isolation region (812), can be formed in the first depth section, and a second conductive channel (702.2, 802.2) of the second conductivity type, which is decoupled from the first conductive channel (702.1,802.1) by a barrier region of the semiconductor body extending in the depth direction between the conductive channels, can be formed in the second depth section, and
- in a second operating state in which third and fourth operating voltages satisfying a resonance condition are applied to the top-gate electrode (804) and the bottom-gate electrode (806), the first and second conductive channels (702.1, 702.2) can be coupled to one another by means of a tunnel effect for minority charge carriers over the barrier region of the semiconductor body.

2. Two-channel semiconductor component (100) according to claim 1, wherein the conductive channels (702.1, 702.2) have a channel length of between 5 and 30 nm.

3. Two-channel semiconductor component (100) according to claim 1 or 2, wherein the barrier region has an extent in the depth direction of between 10 and 30 nm.

4. Two-channel semiconductor component (100) according to any of the preceding claims, having
- a second source region (818) which is laterally arranged between the first source region (808) and the top-gate electrode (704, 804), has a smaller depth extent than the first source region (808) and is laterally electrically isolated from the latter by the first source isolation region (812), and which is laterally electrically isolated from the top-gate electrode (704, 804) by a second source isolation region (822),
- a second drain region (820) which is laterally arranged at a greater distance from the top-gate electrode (804) than the first drain region (810), has a greater depth extent than the first drain region (810) and is laterally electrically isolated from the latter by a second drain isolation region (824), and which extends into the second depth section,
- wherein respective dimensions of the first and second source regions (808, 818), of the first and second drain regions (810, 820), of the first and second source isolation regions (812, 822), and of the first and second drain isolation regions (814, 824) in the depth direction are chosen such that the first conductive channel (702.1, 802.1) extends in the lateral direction between the second source region (818) and the first drain region (810), and that the second conductive channel (702.2, 802.2) extends in the lateral direction between the first source region (808) and the second drain region (820).

5. Signal mixer which comprises a two-channel semiconductor component (100) according to any of the preceding claims, and to which a first input signal is supplied via the bottom-gate electrode (706), and to which a second input signal is supplied via the source electrode (108), and at the drain electrode (110) of which an output signal can be tapped via an output resistor.

6. Detector component for electromagnetic waves, comprising a two-channel semiconductor component according to any of claims 1 to 3.

## Revendications

1. Dispositif semi-conducteur à double canal (100) comprenant
- un corps semi-conducteur dopé (102) d'un premier type de conductivité réalisé en un matériau semi-conducteur du groupe IV ;
- une électrode de grille supérieure du côté supérieur (104, 704, 804) ;
- une électrode de grille inférieure du côté inférieure (106, 706, 806),
- une première électrode de source (108) ayant une première région de source dopée (708, 808) d'un deuxième type de conductivité opposé au premier type de conductivité formée dans le corps semi-conducteur (102),
- une première électrode de drain (110) ayant un corps semi-conducteur (102) formé d'une première région de drain dopée (710, 810) du deuxième type de conductivité, dans lequel
- la première région de source (708, 808) présente une plus grande profondeur dans le corps semi-conducteur (102) que la première région de drain (710, 810) et qui divise le corps semi-conducteur (102) en une première section de profondeur atteignant un bord inférieur de la première région de source (708, 808), et en une deuxième section de profondeur, qui s'étend dans le sens de la profondeur depuis la première section de profondeur jusqu'au côté inférieure du corps semi-conducteur ;
- vu latéralement entre la première région de source (708, 808) et l'électrode de grille supérieure (804) une première région d'isolation de source (712, 812) est agencée, qui isole électriquement l'électrode de source (108) et l'électrode de grille supérieure (804) l'une de l'autre et qui s'étend dans le sens de la profondeur dans la première section de profondeur du corps semi-conducteur mais pas dans la deuxième section de profondeur ;
- vu latéralement entre la première région de drain (710, 810) et l'électrode de grille supérieure (804), une première région d'isolation de drain (714, 814) est agencée, qui isole électriquement l'électrode de drain (110) et l'électrode de grille supérieure (804) l'une de l'autre et qui s'étend dans le sens de la profondeur jusqu'au bord inférieur d'une couche d'isolation de grille de l'électrode de grille supérieure (804) ; dans lequel
- les dimensions respectives de la première région de source (808), de la première région de drain (810), de la première région d'isolation de source (812) et de la première région d'isolation de drain (814) sont choisies dans le sens de la profondeur de sorte que
- dans un premier état de fonctionnement, dans lequel l'électrode de grille supérieure (804) et l'électrode de grille inférieure (806) sont soumises à des première et deuxième tensions de fonctionnement respectives, dans la première section de profondeur un premier canal de conductivité (702.1, 802.1) du deuxième type de conductivité, séparé latéralement de la première région de source (808) par la première région d'isolation de source (812) peut être formé, et dans la deuxième section de profondeur un deuxième canal de conductivité (702.2, 802.2) du deuxième type de conductivité peut être formé, qui est découplé par rapport au premier canal de conductivité (702.1, 802.1) par une région de barrière du corps semi-conducteur s'étendant dans le sens de la profondeur entre les canaux de conductivité, et
- dans un deuxième état de fonctionnement, dans lequel l'électrode de grille supérieure (804) et l'électrode de grille inférieure (806) sont soumises à des troisième et quatrième tensions de fonctionnement respectant une condition de résonance, les premier et deuxième canaux de conductivité (702.1, 702.2) peuvent être couplés l'un à l'autre au moyen d'un effet tunnel pour les porteurs de charge minoritaires à travers la région barrière du corps semi-conducteur et au-delà de celle-ci.

2. Dispositif semi-conducteur à double canal (100) selon la revendication 1, dans lequel les canaux de conductivité (702.1, 702.2) ont une longueur de canal comprise entre 5 et 30 nm.

3. Composant semi-conducteur à double canal (100) selon la revendication 1 ou 2, dans lequel la région barrière a une étendue dans le sens de la profondeur comprise entre 10 et 30 nm.

4. Composant semi-conducteur à double canal (100) selon l'une quelconque des revendications précédentes, avec
- une deuxième région de source (818),
qui est agencée latéralement entre la première région de source (808) et l'électrode de grille supérieure (704, 804), présentant une extension en profondeur plus petite que la première région de source (808) et électriquement isolée de celle-ci latéralement par la première région d'isolation de source (812), et qui est isolée électriquement latéralement de l'électrode de grille supérieure (704, 804) par une deuxième région d'isolation de source (822),
- une deuxième région de drain (820) qui est agencée latéralement plus éloignée que la première région de drain (810) de l'électrode de grille supérieure (804), présente une extension en profondeur plus grande que la première région de drain (810) et qui est isolée électriquement latéralement de celle-ci par une deuxième région d'isolation de drain (824), et qui s'étend dans la deuxième partie de profondeur,
- dans lequel les dimensions respectives des première et deuxième régions de source (808, 818), des première et deuxième régions de drain (810, 820), des première et deuxième régions d'isolation de source (812, 822) et des première et deuxième régions d'isolement de drain ( 814, 824) sont sélectionnés dans le sens de la profondeur de sorte que le premier canal de conductivité (702.1, 802.1) s'étend dans le sens latéral entre la deuxième région de source (818) et la première région de drain (810) et le deuxième canal de conductivité (702.2, 802.2) s'étend dans le sens latérale entre la première région de source (808) et la deuxième région de drain (820).

5. Mélangeur de signaux, comprenant un composant semi-conducteur à double canal (100) selon l'une quelconque des revendications précédentes, auquel un premier signal d'entrée est fourni via l'électrode de grille inférieure (706), auquel un deuxième signal d'entrée est fourni via l'électrode de source (108), et sur l'électrode de drain (110) de celui-ci un signal de sortie peut être prélevé via une résistance de sortie.

6. Dispositif détecteur d'ondes électromagnétiques comprenant un dispositif semi-conducteur à double canal selon l'une quelconque des revendications 1 à 3.
